# FASCICULE DE BREVET EUROPEEN

(11) **EP 2 220 702 B1**
(45) Date de publication et mention de la délivrance du brevet: **28.09.2011**
(21) Numéro de dépôt: 08872326.7
(22) Date de dépôt: 08.12.2008
(51) Int. Cl.: H01L 51/52

(54) **DISPOSITIF COMPORTANT UN COMPOSANT ORGANIQUE ET UNE COUCHE D'ENCAPSULATION AVEC UN MATÉRIAU RÉACTIF À L'HUMIDITÉ**
VORRICHTUNG MIT EINER ORGANISCHEN KOMPONENTE UND EINGEKAPSELTE SCHICHT MIT EINEM FEUCHTIGKEITSREAKTIVEM MATERIAL
DEVICE COMPRISING AN ORGANIC COMPONENT AND AN ENCAPSULATION LAYER WITH A MOISTURE-REACTIVE MATERIAL

(30) Priorité: 14.12.2007 FR 0708743
(43) Date de publication de la demande: 25.08.2010
(73) Titulaire: Commissariat à l'Énergie Atomique et aux Énergies Alternatives, 75015 Paris (FR)
(72) Inventeur: MAINDRON, Tony, F-38000 Grenoble (FR); VAUFREY, DAVID, F-38000 Grenoble (FR)
(74) Mandataire: de Jong, Jean Jacques
(86) Numéro de dépôt international: PCT/FR2008/001703
(87) Numéro de publication internationale: WO 2009/101299

(56) Documents cités:
- EP-A- 1 164 644
- DE-A1-102005 005 579
- US-A1- 2006 077 651
- US-A1- 2006 087 230
- US-A1- 2006 093 795
- US-A1- 2006 170 341

## Description

### Domaine technique de l'invention

L'invention est relative à un dispositif comportant au moins un composant organique disposé sur un substrat, le composant étant recouvert par une couche d'encapsulation, comportant au moins une couche réactive à l'humidité, ladite couche réactive comportant des nodules d'un matériau réactif à l'humidité dispersés dans une matrice.

### État de la technique

Les composants organiques optoélectroniques, par exemple les diodes organiques électroluminescentes, sont de plus en plus utilisées et le nombre de leurs applications ne cesse de grandir. Cependant, pour répondre aux besoins de ces nouvelles applications, il devient nécessaire de réaliser des moyens de protection transparents de plus en plus petits et résistant à l'environnement extérieur. En effet, si les diodes électroluminescentes organiques ne sont pas protégées ou si leur protection n'est pas bien adaptée aux conditions extérieures, les diodes se détériorent. La dégradation des diodes provient essentiellement de l'humidité de l'atmosphère extérieure qui traverse les moyens d'encapsulation et qui réagit avec les matériaux constituant la diode.

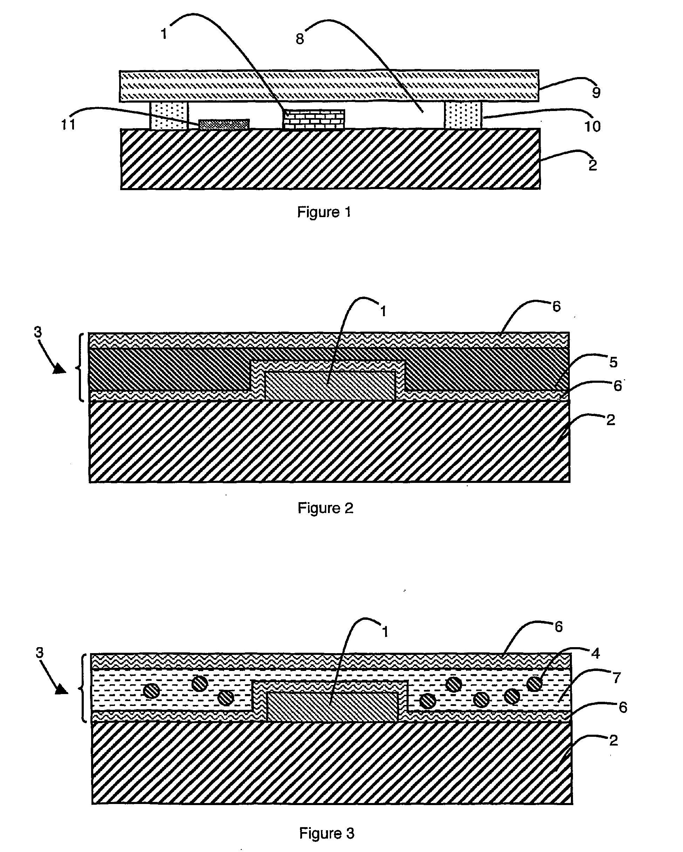

De manière classique, comme illustré à la figure 1 les diodes sont encapsulées dans une cavité fermée 8 délimitée entre un capot de verre 9 et un substrat 2 sur lequel la diode 1 est intégrée. Cette cavité est délimitée par un cordon de colle 10 qui forme un joint périphérique. Cependant ce cordon de colle 10 présente des performances limitées vis-à-vis de son imperméabilité à l'humidité. Un matériau getter solide 11 est alors placé dans la cavité pour réagir avec l'humidité qui traverse les parois et ainsi préserver la diode. Cependant, ce type d'encapsulation n'est utilisable qu'avec des substrats rigides et/ou avec des cavités qui sont suffisamment grandes pour intégrer un matériau getter à côté de la diode. Ce type d'intégration est donc difficilement industrialisable pour les produits courant à faible coût de revient.

Il est également connu d'utiliser une encapsulation monolithique, c'est-à-dire une encapsulation constituée par une ou plusieurs couches possédant d'excellentes qualités barrières vis-à-vis de l'humidité, par exemple des empilements Al₂O₃/polymère/Al₂O₃ ou SiOₓ/SiN/SiOₓ. Cependant, l'épaisseur de la couche d'encapsulation étant limitée, l'imperméabilité de la couche d'encapsulation ne permet pas d'assurer une tenue suffisante dans le temps.

Le document US2006/0087230 A1 décrit la formation d'une couche réactive à l'humidité pour un dispositif organique électroluminescent. La couche réactive comporte un matériau réactif (p. ex. alcalin) incorporé dans une matrice polymérique.

### Objet de l'invention

L'invention a pour but un dispositif ayant une couche d'encapsulation qui soit facile à mettre en oeuvre et qui assure une protection accrue d'un composant organique optoélectronique vis-à-vis de l'humidité de l'atmosphère extérieure.

Selon l'invention, ce but est atteint par les revendications annexées et plus particulièrement par le, fait que ladite matrice étant organique, ledit matériau réactif à l'humidité est choisi parmi les matériaux alcalino-terreux et les alcalins, ladite matrice organique étant choisie parmi les matériaux à base de naphthylphenylbiphenyl (BPhen), à base de 8-hydroxyquinoline, à base de Spiro TAD, à base de Spiro TTB, à base de Spiro-NPB, à base de Spiro- et à base de BCP.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels
La figure 1 illustre, en coupe, un dispositif selon l'art antérieur.
Les figures 2 et 3 représentent, en coupe, deux modes particuliers de réalisation d'un dispositif selon l'invention.

### Description de modes de réalisation préférentiels de l'invention

Comme illustré à la figure 2, au moins un composant organique 1 est disposé sur un substrat 2, pour former tout ou partie d'un dispositif. Le composant organique 1 peut être un émetteur de lumière et/ou un récepteur de lumière, par exemple une diode électroluminescente organique ou une cellule photovoltaïque. Le composant organique 1 peut être également un transistor organique. Le substrat 2 peut être un substrat rigide, par exemple en silicium ou en verre, ou un substrat souple, par exemple en matériau polymère, par exemple en PET (PolyEthylène Téréphtalate) ou en PEN. (PolyEthylène Naphtalène). Le dispositif comporte au moins une face transparente permettant la transmission de la longueur de travail du composant organique optoélectronique 1 si le composant est un composant émetteur et/ou récepteur de lumière.

Le composant organique 1, disposé sur le substrat 2, est recouvert par une couche d'encapsulation 3 pour le protéger de l'humidité de l'environnement extérieur. La couche d'encapsulation 3 comporte une couche 5 continue et réactive à l'humidité, comportant elle-même un matériau réactif à l'humidité. La couche d'encapsulation comporte également une couche 6 en matériau barrière, qui présente une faible perméabilité à l'humidité de l'atmosphère extérieure.

Dans le mode de réalisation particulier illustré à la figure 2, la couche 5 réactive à l'humidité est constituée par un film continu en matériau réactif à l'humidité, sur lequel est déposée la couche barrière 6.

Dans un second mode de réalisation illustré à la figure 3, la couche 5 réactive à l'humidité est constituée par une pluralité de nodules 4 en matériau réactif à l'humidité dispersés dans une matrice organique 7.

Le matériau réactif à l'humidité est par exemple un matériau choisi parmi les éléments alcalins, les éléments alcalino-terreux ou un alliage à base de l'un de ces matériaux. Le matériau réactif est, de préférence, en calcium Ca, Césium Ce ou en baryum Ba, déposé par dépôt physique en phase vapeur. Cependant, le matériau réactif à l'humidité peut également être un dérivé organo-métallique, par exemple AlQ3 (tris(8-hydroxyquinolinato)aluminium), GaQ3 ou InQ3.

Si la couche 5 est constituée par un film continu en élément alcalin ou alcalino-terreux, son épaisseur est typiquement de l'ordre de quelques monocouches atomiques, ce qui lui permet de rester transparente. L'épaisseur de la couche réactive 5 est avantageusement inférieure à 5nm. Une épaisseur plus importante peut être utilisée si la couche d'encapsulation peut être sensiblement opaque, par exemple dans le cas où une diode électroluminescente organique émet un rayonnement lumineux à travers le substrat (« bottom emission » en anglais) ou si le composant est un transistor organique. La couche réactive 5 peut également être également en AlQ3 ayant typiquement une épaisseur comprise entre 50 et 100nm.

Si la couche 5 est constituée par une matrice organique 7 comportant des nodules en matériau 4 réactif à l'humidité, la matrice organique 7 est choisie parmi les matériaux transparents dans la longueur d'onde de travail du composant 1, si l'on souhaite obtenir une couche 5 transparente.

Avantageusement, la matrice organique 7 est choisie parmi les matériaux à base de BPhen (4,7-diphenyl-1,10-phenanthroline), à base de 8-hydroxyquinoline, à base de Spiro-TAD (2,2',7,7'-Tetrakis-(di-phenylamino)-9,9'-spirobifluorene), à base de Spiro-TTB(2,2',7,7'-Tetrakis-(N,N'-di-p-methylphenylamino)-9,9'-spirobifluorene), à base de Spiro-NPB (N,N'-Diphenyl-N,N'-bis(1-naphthyl)-1,1'-biphenyl-4,4'-diamine), à base de Spiro-TPD (2,2',7,7'-Tetra-(m-tolyl-phenylamino)-9,9'-spirobifluorene), à base de TMM4, à base de SEB010, à base de BCP. L'épaisseur de la matrice organique est typiquement inférieure ou égale à 100nm si l'on souhaite que cette couche reste transparente. Cependant, des épaisseurs plus importantes peuvent être intégrées si la transparence n'est pas recherchée. Ces matériaux sont avantageux à utiliser s'ils sont déjà intégrés dans le procédé de réalisation de la diode, en tant que couches organiques actives. Ils peuvent notamment être déposés dans la même enceinte de dépôt que la diode elle-même.

De manière également avantageuse, la matrice organique 7 contient, moins de 2% en poids de matériau réactif à l'humidité pour rester transparent. A titre d'exemple, la couche 5 réactive à l'humidité peut être constituée par une couche de BPhen (4,7-diphenyl-1,10-phenanthroline) comprenant 2% de calcium.

De préférence, le couple (épaisseur/concentration en matériau réactif à l'humidité) de la couche réactive 5 est définie de manière à ce que la couche réactive 5 soit transparente.

Comme illustré sur les figures 2 et 3, une couche barrière 6 est disposée sur la couche 5 réactive pour retarder le contact entre l'humidité de l'environnement extérieur et la couche 5 réactive. Avantageusement, la couche d'encapsulation 3 comporte une autre couche barrière 6, qui sépare la couche réactive 5 du composant organique optoélectronique 1.

Lorsque la couche barrière 6 est déposée sur la couche 5 réactive, cette couche réactive et notamment le matériau de la matrice organique doit être compatible avec un tel dépôt. On privilégiera alors, les matériaux organiques dont la température de transition vitreuse est suffisamment élevée, par exemple supérieure à 100°C, afin d'éviter d'éventuels problèmes de cristallisation. Le Bphen ayant une température de transition vitreuse faible, avantageusement, il ne sera pas utilisé.

De préférence, la couche d'encapsulation 3 est constituée par une alternance de couches barrières 6 et de couches réactives 5, la couche d'encapsulation 3 commençant et se terminant alors par une couche barrière 6.

La couche barrière 6 est avantageusement en alumine (Al₂O₃), déposée par dépôt par couche atomique (« Atomic Layer Deposition » en anglais). Cependant, la couche barrière 6 peut être, par exemple, en oxyde de silicium (SiO₂), en nitrure de silicium stoechiométrique ou non (SiₓN_{y}), ou en oxynitrure de silicium (SiOₓN_{y}) et être déposée par dépôt chimique en phase vapeur assisté par plasma ou par dépôt par couche atomique. L'épaisseur de la couche barrière 6 est typiquement comprise entre 5 et 100nm.

Si la transmission de la lumière se fait au travers de la couche d'encapsulation 3, l'épaisseur des différentes couches constituant la couche d'encapsulation est alors choisie pour qu'elle soit transparente.

Si la couche 5 réactive est constituée par des films continus en matériau 4, l'épaisseur totale en couche 5 réactive est avantageusement inférieure ou égale à 5 nm pour des couches 5 en calcium et inférieure ou égale à 100nm pour des couches 5 en AlQ3. Par ailleurs, si la couche 5 réactive est constituée par des films en matrice organiques avec de nodules 4 en matériau, cette épaisseur totale est avantageusement inférieure à 100nm.

Avantageusement, si le substrat est en plastique ou en polymère, une couche supplémentaire réactive à l'humidité peut être disposée entre le composant 1 et le substrat 2.

Des nodules 4 en matériau réactif peuvent également être disposés dans le substrat si celui-ci ne présente pas de caractéristiques intrinsèques suffisantes pour faire barrière à l'humidité.

## Revendications

1. Dispositif comportant au moins un composant organique (1) disposé sur un substrat (2), le composant (1) étant recouvert par une couche d'encapsulation (3) comportant au moins une couche (5) réactive à l'humidité, ladite couche réactive comportant des nodules (4) d'un matériau réactif à l'humidité (4) dispersés dans une matrice organique (7), ledit matériau réactif à l'humidité étant choisi parmi les matériaux alcalino-terreux et les alcalins, **caractérisé en ce que** ladite matrice organique est choisie parmi les matériaux à base de naphthylphenylbiphenyl (BPhen, 4,7-diphenyl-1,10-phenanthroline), à base de 8-hydroxyquinoline, à base de Spiro-TAD (2,2',7,7'-Tetrakis-(di-phenylamino)-9,9'-spirobifluorene), à base de Spiro-TTB (2,2',7,7'-Tetrakis-(N,N'-di-p-methylphenylamino)-9,9'-spirobifluorene), à base de Spiro-NPB (N,N'-Diphenyl-N,N'-bis(1-naphthyl)-1,1'-biphenyl-4,4'-cliamine), à base de Spiro-TPD (2,2',7,7'-Tetra-(m-tolylphenylamlno)-9,9'-spirobifluorene) et à base de BCP (2,9-dimethyl-4,7-diphenyl-1,10-phenanthrolline).

2. Dispositif selon la revendication 1, **caractérisé en ce que** le matériau réactif à l'humidité est choisi parmi le calcium, le césium et le baryum.

3. Dispositif selon la revendication 2, **caractérisé en ce que** le matériau réactif à l'humidité est le calcium et la matrice organique est un matériau à base de naphthylphenylbiphenyl (BPhen 4,7-diphenyl-1,10-phenanthroline).

4. Dispositif selon l'une quelconque des revendications 1 à 3, **caractérisé en ce que** la couche (5) réactive à l'humidité est constituée par un film continu dudit matériau réactif à l'humidité.

5. Dispositif selon l'une quelconque des revendications 1 à 4, **caractérisé en ce qu'**il comporte au moins une couche barrière (6).

6. Dispositif selon la revendication 5, **caractérisé en ce qu'**une couche barrière (6) est disposée au-dessus de la couche (5) réactive.

7. Dispositif selon l'une des revendications 5 et 6, **caractérisé en ce qu'**une couche barrière (6) est disposée entre la couche (5) réactive et le composant (1).

8. Dispositif selon la revendication 5, **caractérisé en ce que** la couche d'encapsulation (3) est constituée par une alternance de couches barrières (6) et de couches (5) réactives.

9. Dispositif selon l'une quelconque des revendications 1 à 8, **caractérisé en ce que** le substrat (2) est en matériau polymère.

10. Dispositif selon l'une quelconque des revendications 1 à 9, **caractérisé en ce qu'**une couche supplémentaire réactive à l'humidité est disposée entre le composant (1) et le substrat (2).

11. Dispositif selon l'une quelconque des revendications 1 à 10, **caractérisé en ce que** le composant organique (1) est une diode électroluminescente, une cellule photovoltaïque ou un transistor organique.

## Claims

1. Device comprising at least one organic component (1) positioned on a substrate (2), the component (1) being covered by a packaging layer (3), comprising at least one moisture-reactive layer (5), said reactive layer comprising nodules (4) of a moisture-reactive material (4) dispersed in an organic matrix (7), said moisture-reactive material being chosen from alkaline-earth and alkali materials, **characterized in that** said organic matrix is chosen from naphthylphenylbiphenyl (BPhen, 4,7-diphenyl-1,10-phenanthroline) based materials, 8-hydroxyquinoline based materials, Spiro TAD based materials (2,2',7,7'-Tetrakis-(di-phenylamino)-9,9'-spirobifluorene), Spiro TTB based materials (2,2',7,7'-Tetrakis-(N,N'-di-p-methylphenylamino)-9,9'- spirobifluorene), Spiro-NPB based materials (N,N'-Diphenyl-N,N'-bis(1-naphtryl)-1,1'-biphenyl-4,4'-diamine), Spiro-TPD based materials (2,2',7,7'-Tetra-(m-totyl-phenylamino)9,9'- spirobifluorene) and BCP based materials (2,9-dimethyl-4,7-diphenyl-1,10-phenanthroline).

2. Device according to claim 1, **characterized in that** the moisture-reactive material is chosen from calcium, caesium and barium.

3. Device according to claim 2, **characterized in that** the moisture-reactive material is calcium and the organic matrix is a naphthylphenylbiphenyl (BPhen, 4,7-diphenyl-1,10-phenanthroline) based material.

4. Device according to any one of claims 1 to 3, **characterized in that** the moisture-reactive layer (5) is formed by a continuous film of said moisture-reactive material.

5. Device according to any one of claims 1 to 4, **characterized in that** it comprises at least one barrier layer (6).

6. Device according to claim 5, **characterized in that** a barrier layer (6) is positioned above the reactive layer (5).

7. Device according to one of claims 5 and 6, **characterized in that** a barrier layer (6) is positioned between the reactive layer (5) and component (1).

8. Device according to claim 5, **characterized in that** the packaging layer (3) is formed by an alternation of barrier layers (6) and reactive layers (5).

9. Device according to any one of claims 1 to 8, **characterized in that** the substrate (2) is made from polymer material.

10. Device according to any one of claims 1 to 9, **characterized in that** an additional moisture-reactive layer is positioned between the component (1) and substrate (2).

11. Device according to any one of claims 1 to 10, **characterized in that** the organic component (1) is a light-emitting diode, a photovoltaic cell or an organic transistor.

## Patentansprüche

1. Vorrichtung, die wenigstens ein organisches Bauteil aufweist (1), das auf einem Substrat (2) angeordnet ist, wobei das Bauteil (1) von einer Verkapselungsschicht (3) überdeckt ist, die wenigstens eine feuchtigkeitsreaktive Schicht (5) aufweist, wobei die reaktive Schicht Knollen (4) aus einem feuchtigkeitsreaktiven Material (4) aufweist, die in einer organischen Matrix (7) dispergiert sind, wobei das feuchtigkeitsreaktive Material aus Erdalkalimaterialien und Alkalien ausgewählt ist, **dadurch gekennzeichnet, dass** die organische Matrix aus Materialien auf der Basis von Naphthylbiphenyl (BPhen, 4,7-Diphenyl-1,10-phenanthrolin), auf der Basis von 8-Hydroxychinolin, auf der Basis von Spiro-TAD (2,2',7,7'-Tetrakis-(diphenylamino-9,9-spirofluoren), auf der Basis von Spiro-TTB (2,2',7,7'-Tetrakis-(N,N'-di-p-methylpenylamino)-9,9'-spirobifluoren), auf der Basis von Spiro-NPB (N,N'-Diphenyl-N,N'-bis(1-naphthyl)-(1,1'-biphenyl-4,4'diamin), auf der Basis von Spiro-TPD (2,2',7,7'-Tetra-(m-tolyl-phenylamino)-9,9'-spirobisfluorene) und auf der Basis von BCP (2,9-Dimethyl-4,7-diphenyl-1,10-phenanthrolin) ausgewählt ist.

2. Vorrichtung nach Anspruch 1, **dadurch gekennzeichnet, dass** das feuchtigkeitsreaktive Material aus Calcium, Cäsium und Barium ausgewählt ist.

3. Vorrichtung nach Anspruch 2, **dadurch gekennzeichnet, dass** das feuchtigkeitsreaktive Material Calcium ist und die organische Matrix ein Material auf der Basis von Naphthylphenylbiphenyl (BPhen, 4,7-Diphenyl-1,10-phenanthrolin) ist.

4. Vorrichtung nach einem der Ansprüche 1 bis 3, **dadurch gekennzeichnet, dass** die feuchtigkeitsreaktive Schicht durch einen kontinuierlichen Film des feuchtigkeitsreaktiven Materials gebildet ist.

5. Vorrichtung nach einem der Ansprüche 1 bis 4, **dadurch gekennzeichnet, dass** sie wenigstens eine Sperrschicht (6) aufweist.

6. Vorrichtung nach Anspruch 5, **dadurch gekennzeichnet, dass** eine Sperrschicht (6) über der reaktiven Schicht (5) angeordnet ist.

7. Vorrichtung nach einem der Ansprüche 5 und 6, **dadurch gekennzeichnet, dass** eine Sperrschicht (6) zwischen der reaktiven Schicht (5) und dem Bausteil (1) angeordnet ist.

8. Vorrichtung nach Anspruch 5, **dadurch gekennzeichnet, dass** die Verkapselungsschicht (3) durch einen Wechsel von Sperrschichten (6) und reaktiven Schichten (5) gebildet ist.

9. Vorrichtung nach einem der Ansprüche 1 bis 8, **dadurch gekennzeichnet, dass** das Substrat (2) aus Polymermaterial besteht.

10. Vorrichtung nach einem der Ansprüche 1 bis 9, **dadurch gekennzeichnet, dass** eine zusätzliche feuchtigkeitsreaktive Schicht zwischen dem Bauteil (1) und dem Substrat (2) angeordnet ist.

11. Vorrichtung nach einem der Ansprüche 1 bis 10, **dadurch** dass das organische Bauteil (1) eine Elektrolumineszenzdiode, eine Photovoltaikzelle oder ein organischer Transistor ist.
